# EUROPEAN PATENT APPLICATION

(11) **EP 3 276 513 A1**
(43) Date of publication of application: **31.01.2018**
(21) Application number: 17183039.1
(22) Date of filing: 25.07.2017
(51) Int. Cl.: G06F 17/50, G01C 21/20, G01C 21/34, G05D 1/04, G05D 1/06, G05D 1/08, G05D 1/10, G08G 5/00, G08G 5/04

(54) **A METHOD AND AN APPARATUS FOR CALCULATING A DISTANCE IN AN AREA**

(30) Priority: 25.07.2016 NL 2017238
(71) Applicant: Xinaps B.V., 2629 JD Delft (NL)
(72) Inventor: Van Gorp, Geert, 2629 JD Delft (NL); Boumans, Thijs, 2629 JD Delft (NL); Schuyer, Frank, 2629 JD Delft (NL)
(74) Representative: Nederlandsch Octrooibureau

(57) **Abstract**

A method for calculating a distance comprising receiving a map of an area converted as a first polygon; determining a plurality of vertices of the first polygon; determining a pair of the plurality of vertices that does not have an obstruction of the area intersecting a connecting line of the pair; generating a navigation mesh with the pair as a connecting line of the navigation mesh; and determining a distance between two points in the area using the navigation mesh.

## Description

### Field of the invention

The present invention relates to a method and an apparatus for calculating a distance in an area, and more particularly, in an area with obstructions.

### Background art

Modem constructions including buildings, ships, parking lots generally have a complex confined space with obstructions wherein people or objects can move. Often it is desired to know an ideal path and its distance from one location to another location within the construction, such that the people or the objects can move efficiently, or the safety standards of the construction can be fulfilled. This is important in the designing phase of the construction, and also in the everyday use of the construction.

Conventionally a designer or user of the construction can select a desired path in the building with obstructions and calculate the total distance by adding segments of the desired path together. However, in a complex building with obstructions it is cumbersome to perform such a calculation, especially if a significant amount of possible paths is possible.

There is therefore a need to provide a method and an apparatus for calculating a distance in an area with a more efficient manner, such that the people or the objects can move more efficiently, or the safety standards of the construction can be more efficiently fulfilled.

### Summary of the invention

According to a first aspect, the invention provides a method for calculating a distance comprising receiving a map of an area as a first polygon; determining a plurality of vertices of the first polygon; determining a pair of the plurality of vertices that does not have an obstruction of the area intersecting a connecting line of the pair; generating a navigation mesh with the pair as a connecting line of the navigation mesh; determining a distance between two points in the area using the navigation mesh.

Advantageously, by applying the method, a navigation path, and a travel distance in an accessible area can be determined more efficiently using the navigation mesh.

Further embodiments are disclosed in the attached claims.

### Short description of drawings

Embodiments of the present disclosure will be described hereinafter, by way of example only, with reference to the accompanying drawings which are schematic in nature and therefore not necessarily drawn to scale. Furthermore, like reference signs in the drawings relate to like elements.
Fig. 1 schematically shows a model of a construction according to an embodiment of the present disclosure.
Fig. 2 schematically shows a model of a construction according to an embodiment of the present disclosure.
Fig. 3 schematically shows a map of a room with a hole according to an embodiment of the present disclosure.
Fig. 4 schematically shows a polygon with a hole according to an embodiment of the present disclosure.
Fig. 5 schematically shows a polygon with shifted boundaries according to an embodiment of the present disclosure.
Fig. 6 schematically shows a polygon with shifted boundaries and additional vertices according to an embodiment of the present disclosure.
Fig. 7 schematically shows a polygon with filtered vertices according to an embodiment of the present disclosure.
Fig. 8 schematically shows a polygon with filtered vertices and additional vertices according to an embodiment of the present disclosure.
Fig. 9 schematically shows a navigation mesh according to an embodiment of the present disclosure.
Fig. 10 schematically shows an example of determining a shortest path according to an embodiment of the present disclosure.
Fig. 11 schematically shows an example of generating point-to-point navigation according to an embodiment of the present disclosure.
Fig. 12 schematically shows an example of generating a distance map according to an embodiment of the present disclosure.
Fig. 13 schematically shows a flow chart according to an embodiment of the present disclosure.
Fig. 14 schematically shows a device according to an embodiment of the present disclosure.

### Description of embodiments

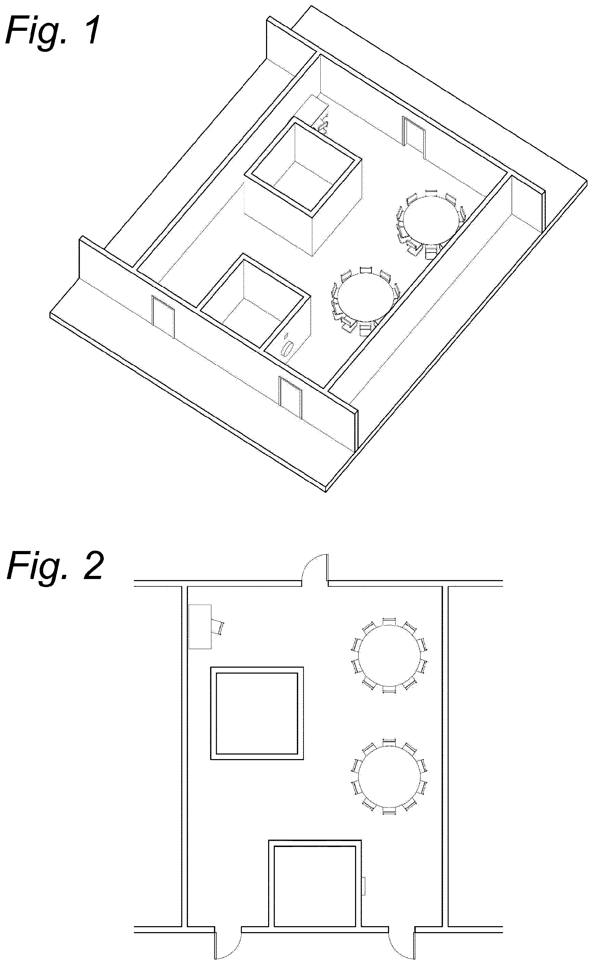

Figures 1 and 2 schematically show a model of a construction. Figure 1 shows a Building Information Model (BIM) of a room. Fig. 2 shows a Computer Aided Design (CAD) of the room. According to an embodiment of the present disclosure, a method for calculating a distance comprises receiving a map of an area converted as a polygon. In this case, data from the BIM or CAD is received as a two-dimensional floor layout, and it is possible to enrich the two-dimensional floor layout information with a third dimension such as a height of an object in the room and other characteristics of the object.

Furthermore, polygons that approximate the layout of the room, a location of navigational start- and/or end points and the so-called navigational transition points such as doors can be required from the BIM or CAD. If no polygons approximating the room are defined in the BIM or CAD, the polygons can be generated by using wall boundaries.

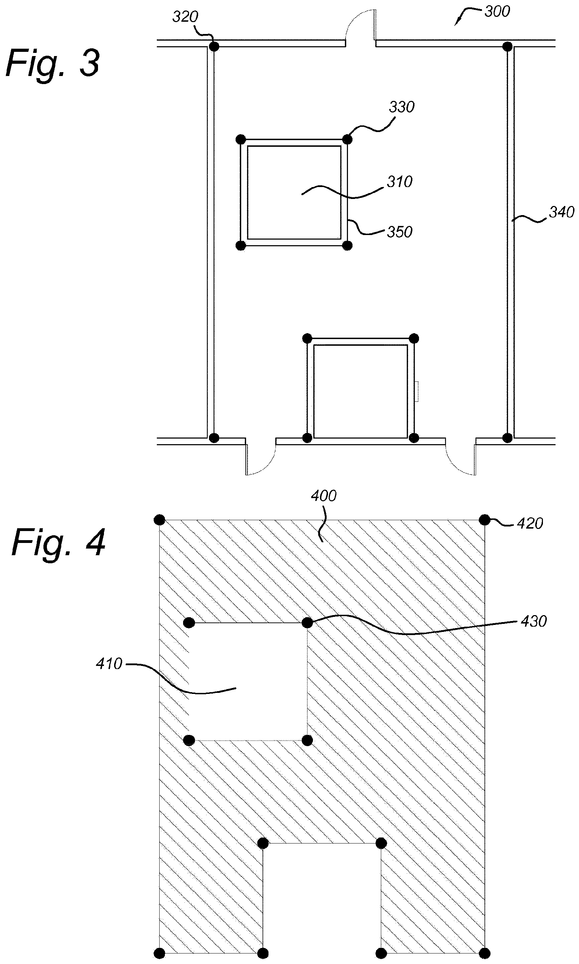

Figure 3 shows a schematic map 300 of the room with a hole 310. Vertices 320, 330 of the edges 340, 350 of the room are superimposed on the map 300. In order to convert a set of lines into polygons, first all edges 340, 350 are identified. Then every edge 340, 350 that shares a vertex 320, 330 with another edge 340, 350 is identified, and stored in a data structure. A vertex 320, 330 is a point where two lines meet to form an angle, and the corners of polygons are vertices.

Once the vertices 320, 330 and the edges 340, 350 are identified, the polygons that approximates the layout of the room can be generated. A room polygon can be defined by walking along a series of outer edges 340 of the room. The hole 310 in the room polygon can be defined by walking along the edges 350 of the hole 310.

If room dimensions do not comply with the functional requirements, such as minimum width, height or any other sizes, the sections of the room which do not comply will be excluded from the polygons. Optionally various other obstructions in the room can be excluded from the polygons, such as furniture, inventory, or any other fixtures inside a room.

Figure 4 shows a room polygon 400 and a hole 410 within the room polygon 400, with vertices 420, 430 superimposed on the room polygon 400 with the hole 410.

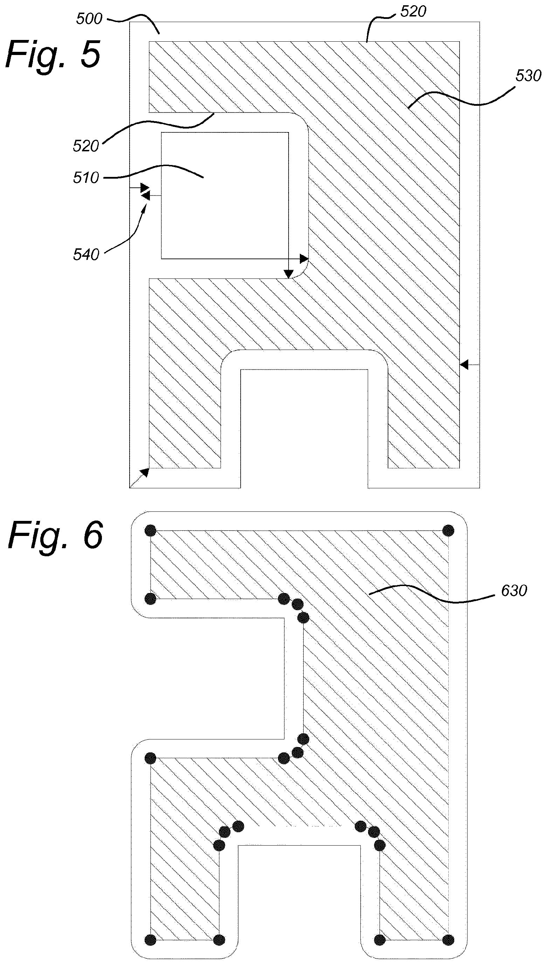

Figure 5 shows a room polygon 500 and a hole 510 within the room polygon 500, with the boundaries 520 of the room polygon 500 and the hole 510 shifted towards the interior of the room polygon 500. The boundaries 520 are shifted inwards by a clearance variable in order to get a clearance from the boundaries 520. This step generates a second polygon 530, which can be called an offset polygon 530. This step can be done by moving the vertices towards the interior of the room polygon 500 along the direction of the vertex normal that is the normalized average of the normal of the two edges. When the distance 540 between two opposite edges is smaller than twice the clearance variable, the corresponding boundary is excluded from the second polygon 530. Note that if the clearance variable is zero, then the second polygon 530 returns to the original shape of the room polygon 500 with the hole 510. The clearance variable can depend on the position of the vertices on the room polygon 500.

Figure 6 shows the offset polygon 630 (identical to the second polygon 530 in Figure 5) with rounded edges by including or adding additional vertex (i.e. polygon points) to the offset polygon 630. The rounded edges are more suitable for a realistic offset navigation, but at the cost of a higher computational complexity. The rounded edges comprise multiple polygon points, each having a normal that is calculated by diffusing the normal of its neighbouring points with a degree accuracy.

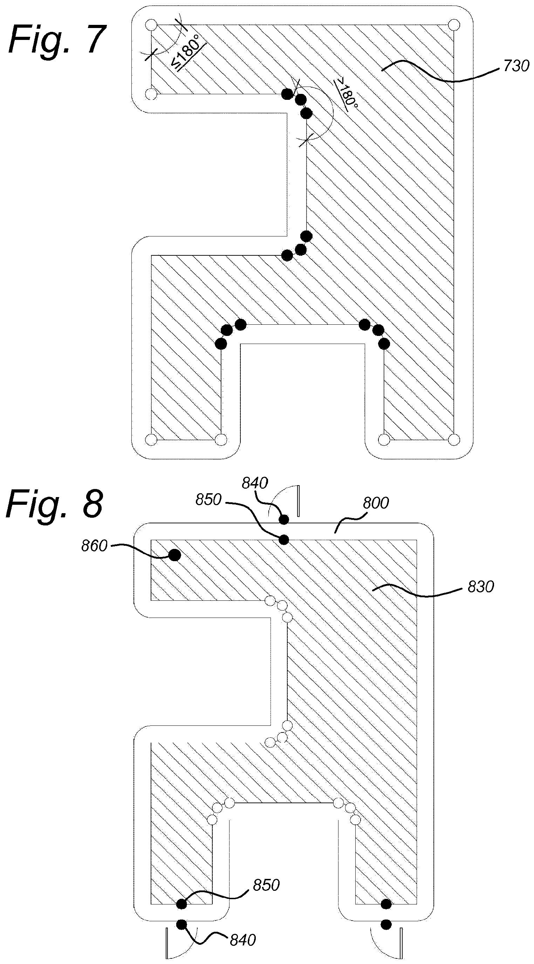

Figure 7 shows the offset polygon 730 (identical to the second polygon 530 in Figure 5) with filtered vertices. To reduce the computational complexity, vertices from the offset polygon 830 with a convex internal angle and vertices of a hole inside the room polygon with a concave internal angle of the hole can be ignored, because these vertices are irrelevant for determining the shortest path in the room. The vertices of the hole inside the room polygon with the concave internal angle of the hole are the vertices of the hole with a convex angle at the interior side of the room polygon.

An angle is convex if it is less than 180°, otherwise it is called concave. An angle is called an internal angle if a point within the angle is in the interior of the polygon. In Figure 7, the unfilled circles are the vertices that can be ignored.

Figure 8 shows the offset polygon 830 and a room polygon 800 with additional nodes 840, 850, 860. The additional nodes 840, 850, 860 can be added to define the "from" and "to" navigation points. A transition node 840, 850 is a transition point to create a room-to-room path. This can be a node for a door, stair, ramp, lift, elevator or any other way of moving between rooms. A transition node linked to one room may be an entrance or exit to the outside. A transition node linked to two rooms will connect a room path to another room path so that a room-to-room pathfinding is defined. Furthermore, a point node 860 is a predefined location in a room, from where a distance path will be started or ended. If a transition point 840 is found inside a room but outside the offset polygon 830, a second point 850 will be moved onto the closest edge of the room polygon 800 along the direction of its normal.

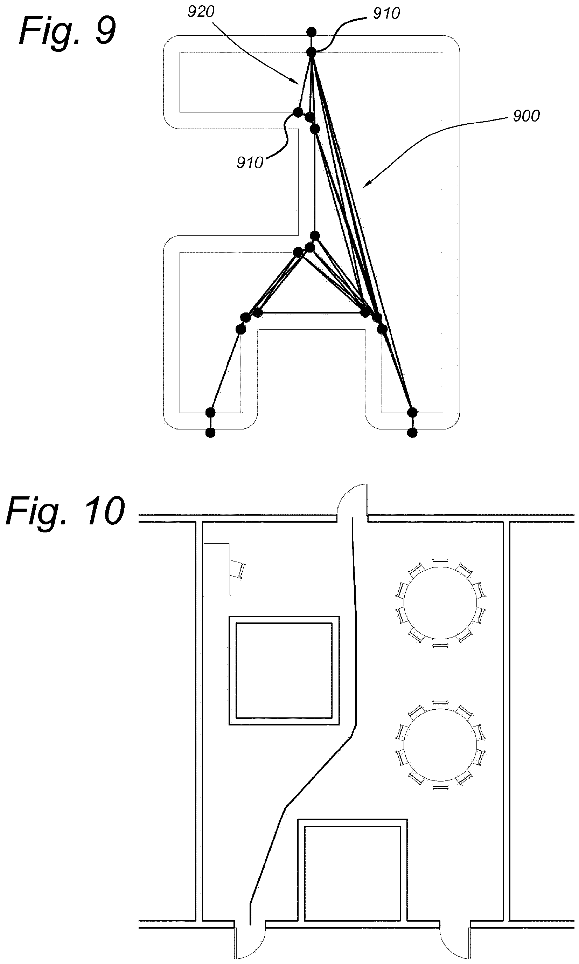

Figure 9 shows a navigation mesh 900 comprising pairs of the vertices 910 that do not have an obstruction of the room intersecting a connecting line 920 of the pairs. The pairs form the connecting line of the navigation mesh. The connecting line can be considered as a connecting edge. The weight of the connecting line is determined by the distance between the nodes. All connecting lines that meet an obstruction are eliminated, which obstruction in this case is the edge of one of the polygons. That means in reality that traveling between these two navigation points involves coming too close to an obstruction. According to an embodiment of the present disclosure, the obstruction can be an edge of the room polygon or/and the edge of the hole or/and the edge of the offset polygon. As a result, every connected pair of points represent the set of possible segments of the navigation path of the shortest distance between any given pair of navigation start- and endpoints.

Note that this operation can be considerably sped up by having a structure to optimize finding elements by location such as a Quadtree tree data structure, but this may not be necessary in relatively simple rooms.

Navigation through multiple rooms is possible by linking together the navigation meshes of the multiple rooms. This can be done by: 1, defining a transition node linked to two rooms; 2, adding an appropriate weight between the sides of the transition node; 3, adding a connecting line between a pair of nodes. The navigation can more accurate by having multiple navigation points per transition node, which allows for navigation horizontally through doors, diagonally over stairs, ramps and escalators, vertically trough elevators, or any other transition object.

Each transition node will be checked upon accessibility requirements, such as the minimum door width, the maximum slope of the ramps, the minimum clear height above the stairs amongst other rule checks. If a transition node does not meet the given requirements of the accessibility profile, the transition node will not be used in the navigation mesh. As a result, the navigation algorithm needs to find another path to access the area, or the area cannot be accessed at all.

According to an embodiment of the present disclosure, the method for calculating a distance can be applied to different such as determining a path between navigation points, generating point-to-point navigation, and generating a distance map.

Figure 10 shows an example of determining a shortest path between two doors in a room. This can be done by taking the navigation mesh and converting it into a graph. After that, several navigation algorithms can be applied that works on graphs such as the Dijkstra's and A* Pathfinding algorithm.

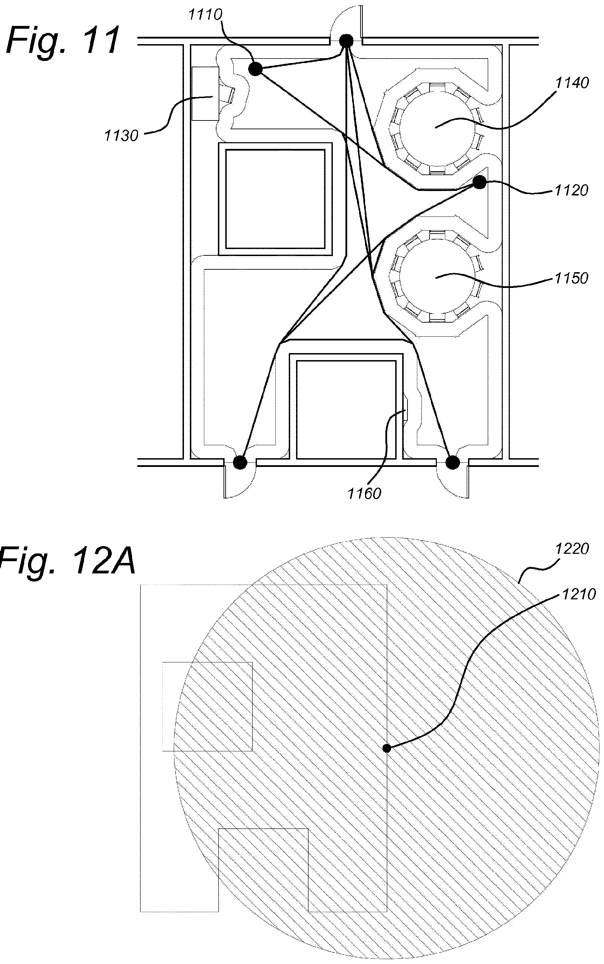

Figure 11 shows an example of generating point-to-point navigation. Additional point nodes 1110, 1120 are added and the corresponding navigation mesh now includes these additional point nodes. Furthermore, obstructions such as furnitures 1130, 1140, 1150, 1160 are included so the navigation mesh is changed accordingly.

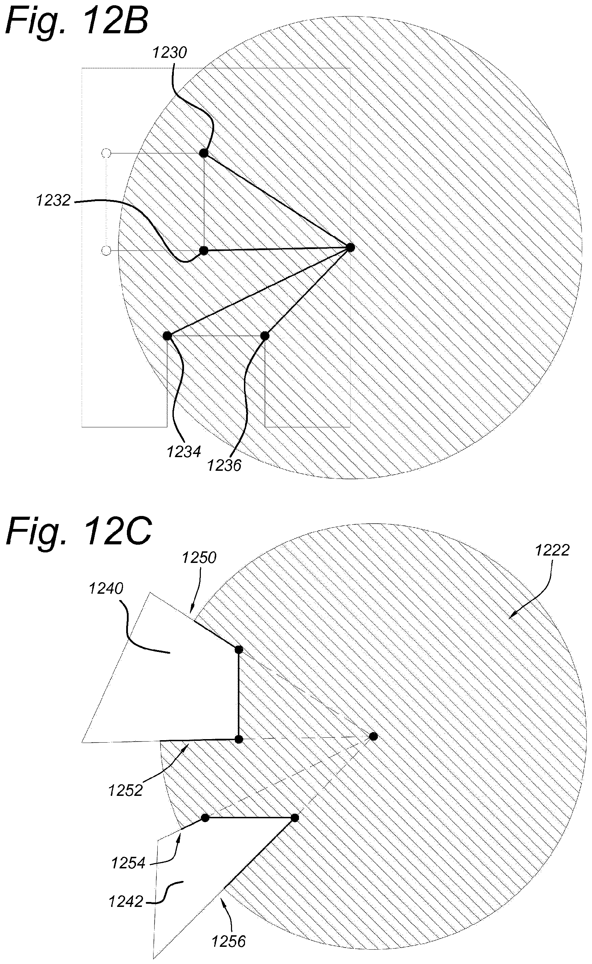

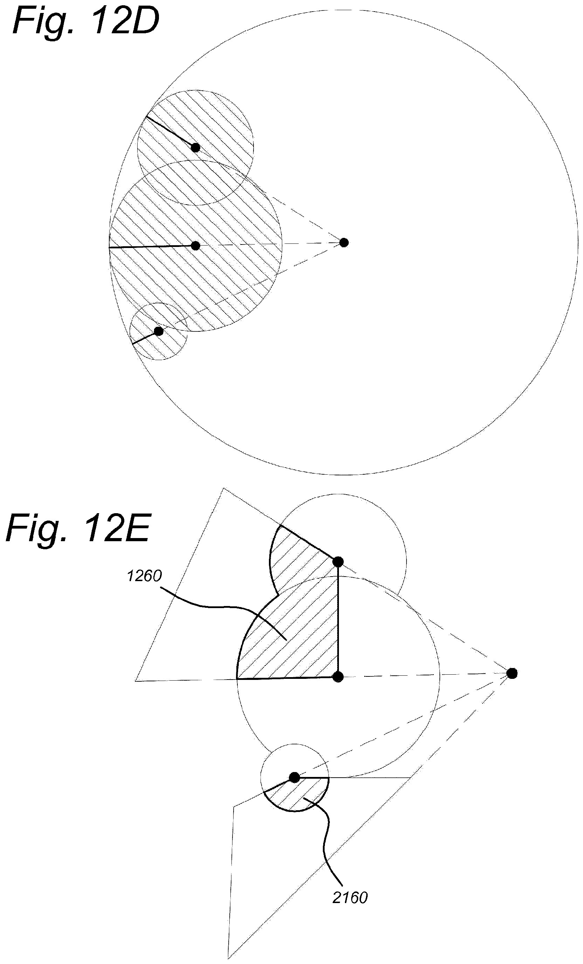

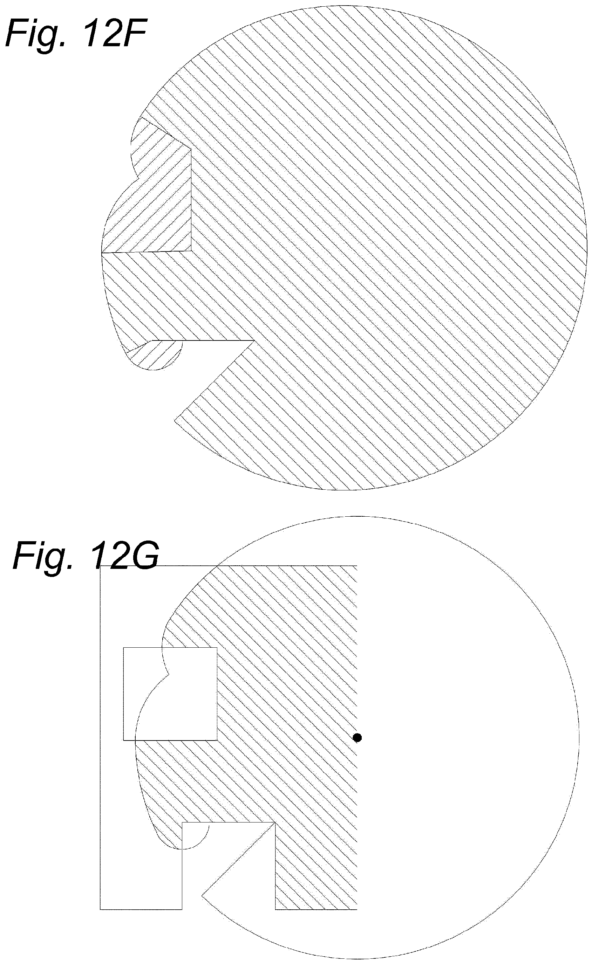

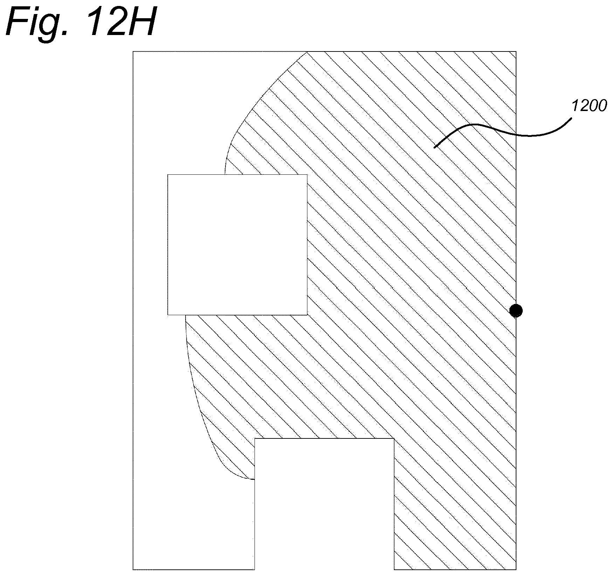

Figures 12 a to h show an example of generating a distance map to visualize the maximum travel distance to an object located at starting point 1210. In this example, the starting point 1210 can be considered as a starting point of a fire hose, and the shaded region 1200 in Figure 12h is the region that the fire hose with a certain length can reach. To determine this region, first a circle 1220 is drawn in Figure 12 a with a radius that equals the length of the fire hose, and the center point of the circle 1220 is the starting point 1210. This is the region that the fire hose can reach if there are no walls and no obstructions in the room. Other examples of objects to generate a maximum travel distance map for, are a fire exit, an operating room in a hospital, or a copier in an office.

Figure 12b shows the connecting lines from the starting point 1210 to four vertices 1230, 1232, 1234, 1236 without intersecting an obstruction in the room. Figure 12c shows two quadrilaterals 1240, 1242, each with two sides 1250, 1252, 1254, 1256 extended from the connecting lines. The remaining area 1222 of the circle 1220 excluding the two quadrilaterals 1240, 1242 is shaded. Figure 12d shows three smaller circles drawn from the vertices 1230, 1232, 1234. Figure 12e shows the area 1260 that the three smaller circles overlap with the two quadrilaterals. Figure 12f shows the combination of the remaining area 1222 and the area 1260. Figure 12g shows this combination superimposed on a room polygon with a hole, and finally Figure 12h shows the region 1200 that the fire hose with a certain length can reach.

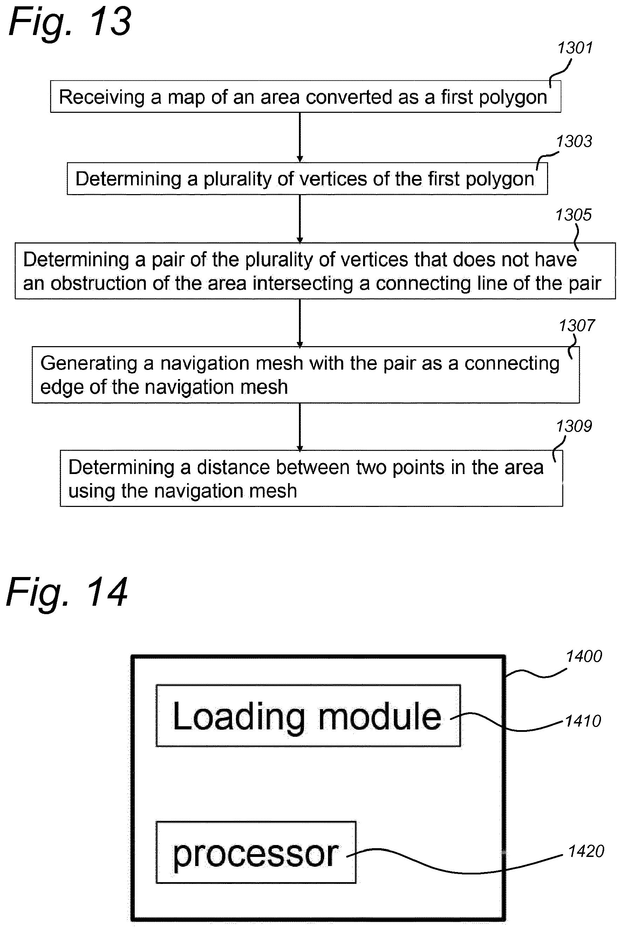

Figure 13 shows a flow chart according to an embodiment of the present invention. In step 1301, a map of an area converted as a first polygon is received. In step 1303, a plurality of vertices of the first polygon is determined. In step 1305, a pair of the plurality of vertices that does not have an obstruction of the area intersecting a connecting line of the pair is determined. In step 1307, a navigation mesh with the pair as a connecting line of the navigation mesh is generated. In step 1309, a distance between two points in the area using the navigation mesh is determined.

Figure 14 shows a device 1400 according to an embodiment of the present invention. The device 1400 for calculating a distance comprises a loading module 1410 configured to receive a map of an area converted as a first polygon; and a processor 1420 configured to determine a plurality of vertices of the first polygon; determine a pair of the plurality of vertices that does not have an obstruction of the area intersecting a connecting line of the pair; generate a navigation mesh with the pair as a connecting line of the navigation mesh; and determine a distance between two points in the area using the navigation mesh.

In the present disclosure, vertices can be considered as nodes or points.

According to an embodiment of the present disclosure, the area is an indoor area. According to an embodiment of the present disclosure, the area can be a confined space in an outdoor area, like a parking lot.

According to an embodiment of the present disclosure, a method is provided for calculating a navigation path and a travel distance in an area comprising receiving a map of an area converted as a first polygon; determining a plurality of vertices of the first polygon; determining a pair of the plurality of vertices that does not have an obstruction of the area intersecting a connecting line of the pair; generating a navigation mesh with the pair as a connecting line of the navigation mesh; creating navigation paths between two points in the area; and determining the travel distance using a navigation algorithm.

The present invention has been described above with reference to a number of exemplary embodiments as shown in the drawings. Modifications and alternative implementations of some parts or elements are possible, and are included in the scope of protection as defined in the appended claims.

In the foregoing description of the figures, the invention has been described with reference to specific embodiments thereof. It will, however, be evident that various modifications and changes may be made thereto without departing from the scope of the invention as summarized in the attached claims.

In addition, many modifications may be made to adapt a particular situation or material to the teachings of the invention without departing from the essential scope thereof. Therefore, it is intended that the invention not be limited to the particular embodiments disclosed, but that the invention will include all embodiments falling within the scope of the appended claims.

In particular, combinations of specific features of various aspects of the invention may be made. An aspect of the invention may be further advantageously enhanced by adding a feature that was described in relation to another aspect of the invention.

It is to be understood that the invention is limited by the annexed claims and its technical equivalents only. In this document and in its claims, the verb "to comprise" and its conjugations are used in their non-limiting sense to mean that items following the word are included, without excluding items not specifically mentioned. In addition, reference to an element by the indefinite article "a" or "an" does not exclude the possibility that more than one of the element is present, unless the context clearly requires that there be one and only one of the elements. The indefinite article "a" or "an" thus usually means "at least one".

Some or all aspects of the invention may be suitable for being implemented in form of software, in particular a computer program product. The computer program product may comprise a computer program stored on a non-transitory computer-readable media. Also, the computer program may be represented by a signal, such as an optic signal or an electro-magnetic signal, carried by a transmission medium such as an optic fiber cable or the air. The computer program may partly or entirely have the form of source code, object code, or pseudo code, suitable for being executed by a computer system. For example, the code may be executable by one or more processors.

## Claims

1. A method for calculating a distance comprising
receiving a map of an area converted as a first polygon (400);
determining a plurality of vertices (420, 430) of the first polygon;
determining a pair (910) of the plurality of vertices that does not have an obstruction of the area intersecting a connecting line (920) of the pair;
generating a navigation mesh (900) with the pair as a connecting line of the navigation mesh; and
determining a distance between two points (910) in the area using the navigation mesh.

2. The method according to claim 1, wherein the first polygon is provided with a hole (410) with vertices (430).

3. The method according to any of the claims 1 to 2, wherein determining a plurality of vertices of the first polygon comprises excluding vertices from the plurality of vertices of the first polygon with a convex internal angle.

4. The method according to claim 3, further comprising excluding vertices of a hole (410) inside the first polygon with a concave internal angle of the hole.

5. The method according to any of the claims 1 to 4, further comprising shifting the plurality of vertices towards the interior of the first polygon by a clearance variable generating a second polygon (530).

6. The method according to claim 5, wherein the clearance variable depends on the position of the plurality of vertices on the first polygon.

7. The method according to any of the claims 5 to 6, further comprising rounding two edges of a vertex of the plurality of vertices by adding an additional vertex to the second polygon.

8. The method according to any of the claims 1 to 7, wherein the connecting line of the navigation mesh has a weight that is the length of the connecting line.

9. The method according to any of the claims 5 to 8, wherein the obstruction of the area comprises an edge of the first polygon or / and the second polygon.

10. The method according to any of the claims 1 to 9, wherein the map of the area comprises data from at least one of a Building Information Model, BIM, and Computer Aided Design, CAD data.

11. The method according to any of the claims 1 to 10, further comprising adding an additional point to the navigation mesh.

12. The method according to any of the claims 1 to 11, wherein determining a distance between two points in the area using the navigation mesh comprises using a navigation algorithm to determine the distance between the two points, for example the navigation algorithm is the Dijkstra's algorithm or the A* Pathfinding algorithm.

13. A method for determining the shortest distance between two points in an area using the method according to any of the claims 1 to 12, or/and for determining a distance map using the method according to any of the claims 1 to 12.

14. A device for calculating a distance comprising
a loading module (1410) configured to
receive a map of an area converted as a first polygon; and
a processor (1420) configured to
determine a plurality of vertices of the first polygon
determine a pair of the plurality of vertices that does not have an obstruction of the area intersecting a connecting line of the pair;
generate a navigation mesh with the pair as a connecting line of the navigation mesh; and
determine a distance between two points in the area using the navigation mesh.

15. A computer program product comprising instructions for causing a computer system to perform the method according to any of the claims 1 to 13.
